# EUROPEAN PATENT APPLICATION

(11) **EP 4 084 083 A1**
(43) Date of publication of application: **02.11.2022**
(21) Application number: 20905673.8
(22) Date of filing: 19.02.2020
(51) Int. Cl.: H01L 29/739, H01L 29/06, H01L 29/423

(54) **TRENCH IGBT CHIP**

(30) Priority: 27.12.2019 CN 201911374310
(71) Applicant: Zhuzhou CRRC Times Semiconductor Co. Ltd, Zhuzhou, Hunan 412005 (CN)
(72) Inventor: NING, Xubin, Zhuzhou, Hunan 412005 (CN); TAN, Zhenhua, Zhuzhou, Hunan 412005 (CN); LI, Di, Zhuzhou, Hunan 412005 (CN); XIAO, Haibo, Zhuzhou, Hunan 412005 (CN); XIAO, Qiang, Zhuzhou, Hunan 412005 (CN)
(74) Representative: Petraz, Gilberto Luigi
(86) International application number: PCT/CN2020/075870
(87) International publication number: WO 2021/128548

(57) **Abstract**

Provide is a trench IGBT chip, comprising an N-type drift layer; a plurality of parallel cells, wherein each cell comprises two main gates disposed in a first trench in the upper surface of the N-type drift layer, and the two main gates extend along the surface of the N-type drift layer and are distributed in parallel; and dummy gates located between the cells and disposed in a second trench in the upper surface of the N-type drift layer, wherein the dummy gates are parallel to the main gates; each of the dummy gates extracts a potential by means of a dummy gate main line; and first dummy gate P wells between the main gates and the dummy gates or a dummy gate P+ contact region in a second dummy gate P well between two dummy gate P wells extract a potential by means of a dummy gate P well main line. By using the trench IGBT chip, the dummy gates and the dummy gate P wells are extracted, such that same can respectively apply different potentials, thereby avoiding a decrease in the device turn-off capability caused by a rise in Vge at the moment of turn-off due to a displacement current which is generated owing to the relatively high Cgc when the dummy gates and the P wells float, and effectively avoiding a voltage or current overshoot during the turn-on and turn-off processes insofar as the performance is not reduced.

## Description

### Cross Reference to Related Applications

The present application claims the priority of Chinese patent application No.201911374310.9, filed on December 27, 2019 and entitled "Trench IGBT chip", which is incorporated herein by reference in its entirety.

### Field of the Invention

The present disclosure relates to the technical field of semiconductor devices, and in particular to a trench IGBT chip.

### Background of the Invention

An insulated gate bipolar transistor (abbreviated as "IGBT") has both the advantages of a metal-oxide-semiconductor field-effect transistor (abbreviated as "MOSFET") of high input impedance and simple gate drive, and the advantages of a bipolar junction transistor (abbreviated as "BJT") of a small conduction voltage drop and a large working current, and is widely used in the fields of industrial control, electric vehicles, rail transit, intelligent power grids, inverter home appliances, etc.

When being conducted, a trench IGBT has a large current density, which will reduce the short circuit resistance capability, and therefore, it is necessary to rationally design the distribution of active regions in order to improve the short circuit resistance capability of a device, thereby ensuring a safe working region of a chip. In general, the expansion of a transverse electric field is restrained by using the dummy gate technology or the floating P well technology, so as to avoid the fact that the blocking voltage withstanding of the IGBT is reduced caused by the occurrence of a transverse voltage peak value. Therefore, there is a P well region of dummy gates and non-effective channel regions. In a current dummy gate structure, an electrical short circuit method is generally used, where a dummy gate is connected to an emitter, or the dummy gate is connected to a gate, or the dummy gate is connected to a field limiting ring of a terminal region, or the dummy gate floats. These current methods have the problems of a switch loss increasing, a surge voltage becoming larger, the voltage withstanding being reduced, etc. The functions of P wells between the dummy gates and main gates and between the dummy gates are different from those of P wells between the main gates. In general, the dummy gate P wells float or are grounded. When the P wells float, a displacement current may be produced upon the turning off since a Miller capacitance Cgc is large, which leads to the increase of a Vge potential, such that the turn-off capability of the device deteriorates. When the P wells are grounded, the capacitance between the gate G and the emitter E becomes larger, the Miller capacitance Cgc decreases and a Cge increases, such that the displacement current upon the turning off is decreased. However, a delay of a chip turn-on process increases, and the controllability of di/dt during the turn-on process gets worse.

### Summary of the Invention

For the above-mentioned problems in the existing technique, the present application provides a new trench IGBT chip. A dummy gate and a dummy gate P well are extracted, such that they can respectively apply different potentials, thereby effectively avoiding a voltage or current overshoot during the turn-on and turn-off processes insofar as the performance is not reduced, and realizing that a current rise rate during the IGBT turn-on process is quantitatively adjusted and the anti-electromagnetic-interference capability is adjusted and improved according to the applications.

The trench IGBT chip provided in the present application includes an N-type drift layer; a plurality of parallel cells, where each of the cells includes two main gates disposed in a first trench, which is formed by etching downwards, in an upper surface of the N-type drift layer, and the two main gates extend along the surface of the N-type drift layer and are distributed in parallel; and dummy gates, where the dummy gates are located between the cells and are disposed in a second trench, which is formed by etching downwards, in the upper surface of the N-type drift layer, and the dummy gates are parallel to the main gates. Each of the dummy gates extracts a potential by means of a dummy gate main line. A dummy gate P+ contact region in a first dummy gate P well between one of the main gates and one of the dummy gates or in a second dummy gate P well between two dummy gate P wells extracts a potential by means of a dummy gate P well main line. By utilizing the trench IGBT chip, the dummy gates and the dummy gate P wells are extracted, such that same can respectively apply different potentials, thereby avoiding a decrease in the device turn-off capability caused by a rise in Vge at the moment of turn-off due to a displacement current which is generated owing to the relatively high Cgc when the dummy gates and the P wells float, and effectively avoiding a voltage or current overshoot during the turn-on and turn-off processes insofar as the performance is not reduced.

In one implementation, the dummy gate main line is connected to an emitter or a gate of a cellular region, and the dummy gate P well main line is connected to the emitter or the gate of the cellular region.

In one implementation, the chip includes more than one dummy gate, where when the first dummy gate P well extracts a potential, the second dummy gate P well floats, or when the second dummy gate P well extracts a potential, the first dummy gate P well floats.

In one implementation, the dummy gate P+ contact region is connected by means of a metal electrode, and a polycrystalline resistor is connected to the dummy gate P well main line.

In one implementation, an isolation oxide layer is disposed between the polycrystalline resistor and the surface of the chip. Through the implementation, the polycrystalline resistor is positioned along the trench direction, and will not affect the cellular region even if the polycrystalline resistor has a potential.

In one implementation, the isolation oxide layer has a thickness of 1000 A to 1300 A.

In one implementation, the chip includes at least two dummy gates. A plurality of transverse trenches are provided between adjacent dummy gates, and are perpendicular to a length direction of the dummy gates, so as to divide the dummy gate P well into a plurality of dummy gate active regions and a plurality of dummy gate dummy regions, which are alternately arranged. The dummy gate P+ contact region is provided in dummy gate P wells in the dummy gate active regions, and dummy gate P wells in the dummy gate dummy regions float. Through the implementation, different quantities of potential P wells can be designed, so as to realize the adjustment of the area of dummy gate P wells, thereby realizing the quantitative adjustment of a current rise rate according to the application requirements, improving the anti-electromagnetic-interference capability of a system, and improving the electromagnetic compatibility between the device and the system.

In one implementation, each of the cells has a hexagonal cellular structure, and the plurality of cells are distributed on the N-type drift layer in a honeycomb shape; or each of the cells has a quadrate cellular structure, and the plurality of cells are distributed on the N-type drift layer in matrix; or each of the cells has a strip-shaped cellular structure, and the plurality of cells are distributed side by side on the N-type drift layer.

In one implementation, the N-type drift layer further includes a through structure, a soft-through structure or a non-through structure below same.

In one implementation, a main gate P well between the two main gates includes a main gate P+ contact region and main gate N+ emitters disposed at opposite sides of the main gate P+ contact region.

In one embodiment, the chip further includes: a P+ collector layer; and an N-type buffer layer disposed between the P+ collector layer and the N-type drift layer.

Compared with the existing technique, the trench IGBT chip provided in the present application has the following beneficial effects.
1) Through the disclosure, the device turn-off capability is avoided from being reduced caused by a rise in Vge at the moment of turn-off due to a displacement current which is generated owing to the relatively high Cgc when the dummy gates and the P wells float.
2) In the disclosure, the connection method for the dummy gate P wells is adjusted via a layout, thereby realizing the quantitative adjustment of a current rise rate (di/dt) according to the application requirements, improving the anti-electromagnetic-interference capability of the system, and improving the electromagnetic compatibility between the device and the system.
3) The IGBT structure with controllable di/dt in the disclosure does not affect the turn-off safe working region of the chip and slightly affects a turn-off loss (Eoff), but can improve the compromise relationship between a turn-on loss (Eon) and a reverse recovery loss (Erec). The grounding proportion of the dummy gate P wells can be increased, so as to decrease a conducting speed di/dt, such that the turn-on loss is increased and the turn-off loss is decreased. The grounding proportion of the dummy gate P wells can be decreased, so as to increase the conducting speed di/dt, such that the turn-on loss is decreased and the Erec is increased.
4) In the disclosure, an electrode can be extracted from the dummy gate P wells, such that the dummy gate P wells apply different potentials in the IGBT conducting, turn-on and turn-off processes, thereby obtaining different performances.

The above-mentioned technical features can be combined in any suitable manner or be replaced by equivalent technical features, as long as the objective of the present disclosure can be achieved.

### Brief Description of the Drawings

The disclosure will be described in more details below based on embodiments and referring to the accompanying drawings. In the drawings:
Fig. 1 shows a partial structural schematic diagram of a trench IGBT chip according to an embodiment of the disclosure;
Fig. 2 shows a sectional view of the trench IGBT chip according to the embodiment of the disclosure;
Fig. 3 shows a sectional view of a trench IGBT chip according to another embodiment of the disclosure;
Fig. 4 shows a top view of a trench IGBT chip according to an embodiment of the disclosure;
Figs. 5 and 6 show sectional views of the trench IGBT chip according to the embodiment of the disclosure;
Fig. 7 shows a top view of a trench IGBT chip according to another embodiment of the disclosure;
Fig. 8 shows a top view of a trench IGBT chip according to a further embodiment of the disclosure;
Fig. 9 shows a diagram of a current rise rate of a trench IGBT chip according to an embodiment of the disclosure changing along with the area of dummy P wells;
Fig. 10 shows a structural schematic diagram of a trench IGBT chip according to another embodiment of the disclosure;
Fig. 11 shows a sectional view of the trench IGBT chip according to the another embodiment of the disclosure; and
Fig. 12 shows a sectional view of a trench IGBT chip according to a further embodiment of the disclosure.

### List of Reference Numbers

- 100: Trench IGBT chip
- 110: P+ collector layer
- 120: N-type buffer layer
- 130: N-type drift layer
- 140: Main gate
- 141: First trench
- 142: Gate oxide layer
- 143: Main gate P+ contact region
- 144: Main gate N+ emitter
- 150: Dummy gate
- 151: Second trench
- 152: Dummy gate main line
- 153: Dummy gate P+ contact region
- 154: Dummy gate P well main line
- 155: Contact aperture
- 156: Metal layer
- 157: Polycrystalline resistor
- 158: Isolation oxide layer
- 160: Transverse trench
- 170: Dummy gate active region
- 171: Dummy gate dummy region
- 180: First dummy gate P well
- 190: Second dummy gate P well
- 200: Busbar

### Detailed Description of the Embodiments

The disclosure will be further described below in conjunction with the accompanying drawings.

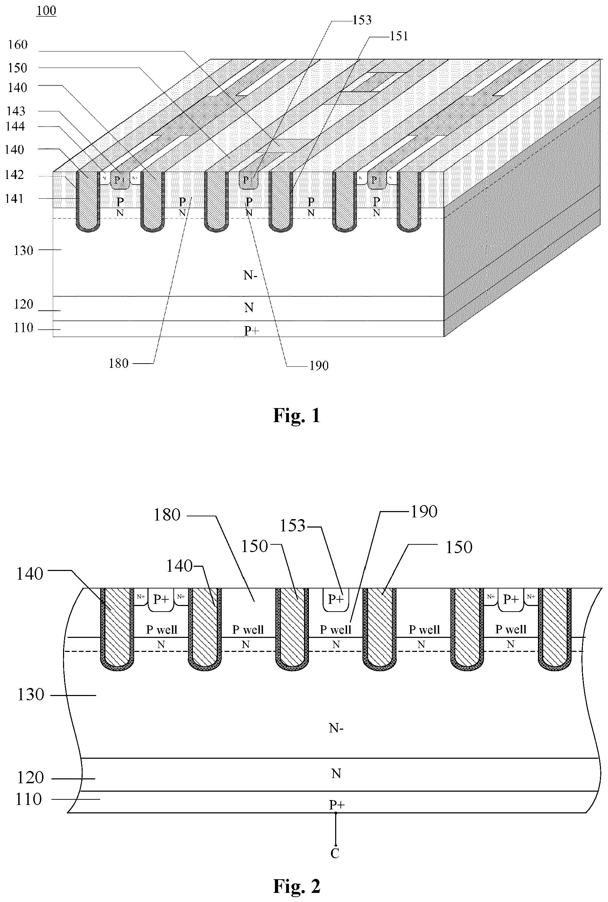

Fig. 1 is a partial schematic perspective view of a trench IGBT chip 100 according to the disclosure. As shown in Fig. 1, the trench IGBT chip 100 may include a P+ collector layer 110, an N-type buffer layer 120 and an N-type drift layer 130, which are sequentially stacked from bottom to top. A plurality of parallel cells may be disposed on an upper surface of the trench IGBT chip 100. Each of the cells includes an active region and a gate region. The gate region includes two main gates 140, which are arranged in parallel. The main gates 140 are each disposed in a respective first trench 141, which is formed by etching downwards, in an upper surface of the N-type drift layer 130. A gate oxide layer 142 is disposed on a sidewall of the first trench 141. The active region between the main gates includes a main gate N well and a main gate P well, which are distributed from bottom to top. The main gate P well includes a main gate P+ contact region 143 and main gate N+ emitters 144 disposed at opposite sides of the main gate P+ contact region 143. Lateral parts of the main gate N well, the main gate P well, the main gate P+ contact region 143 and the main gate N+ emitter 144 of the active region terminate at the gate oxide layer 142. The main gate P+ contact region 143 and the main gate N+ emitters 144 are electrically short circuited, and are connected to the outside via a metal layer.

In Fig. 1, one or more dummy gates 150 may be disposed between adjacent parallel cells (i.e., between the main gates). Similarly to the main gate 140, the dummy gate 150 is disposed in a second trench 151, which is formed by etching downwards, in the upper surface of the N-type drift layer 130, and the gate oxide layer 142 is disposed on the sidewall of the second trench 151.

Optionally, a width and a depth of the first trench 141 and a width and a depth of the second trench 151 may be same as each other, and may also be different from each other, which is not limited herein.

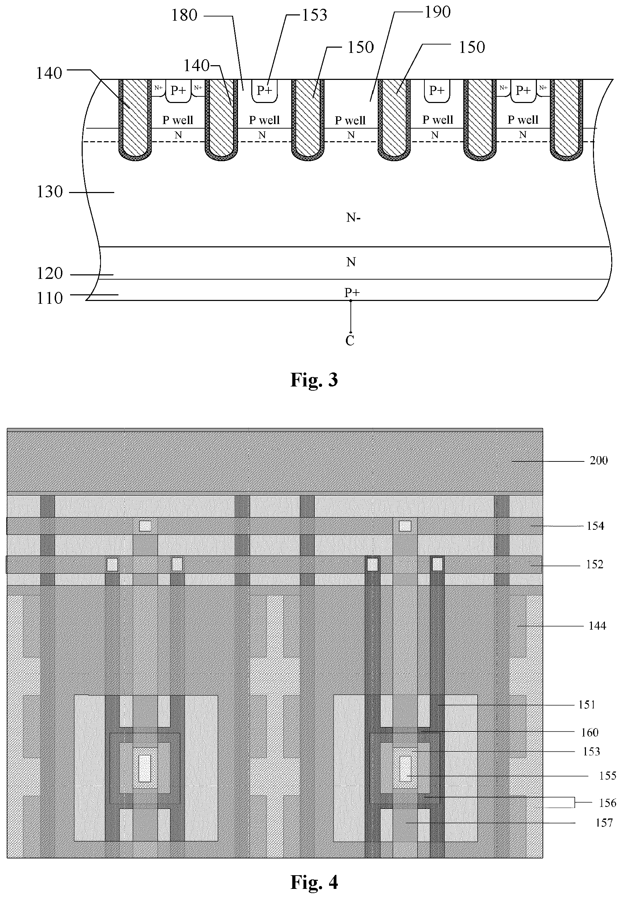

For the purpose of illustration, two dummy gates 150 are taken as an example to illustrate the situation where a trench IGBT chip contains a plurality of dummy gates 150. In one embodiment, as shown in Figs. 1 and 2, two dummy gates 150 are included between adjacent cells, and the two dummy gates 150 are distributed parallel to the main gates 140 and parallel to each other. As shown in detail in Fig. 4, the dummy gate 150 may extract a potential by means of a dummy gate main line 152 (see Fig. 4), and the dummy gate main line 152 may be connected to an emitter or a gate in a cellular region. A dummy gate active region between two dummy gates 150 includes a dummy gate N well and a dummy gate P well, which are distributed from bottom to top. The dummy gate P well includes a first dummy gate P well 180 between a main gate 140 and a dummy gate 150 and a second dummy gate P well 190 between two adjacent dummy gates 150. The second dummy gate P well 190 merely includes a dummy gate P+ contact region 153 but does not include an emitter. The dummy gate P+ contact region 153 may extract a potential by means of a dummy gate P well main line 154 (see Fig. 4). The dummy gate P well main line may be connected to the emitter or the gate in the cellular region, or connected to an external potential by means of an electrode. In another aspect, a first dummy gate P well 180 located between one side of the main gate 140 where a conductive trench is not present and the dummy gate 150 floats.

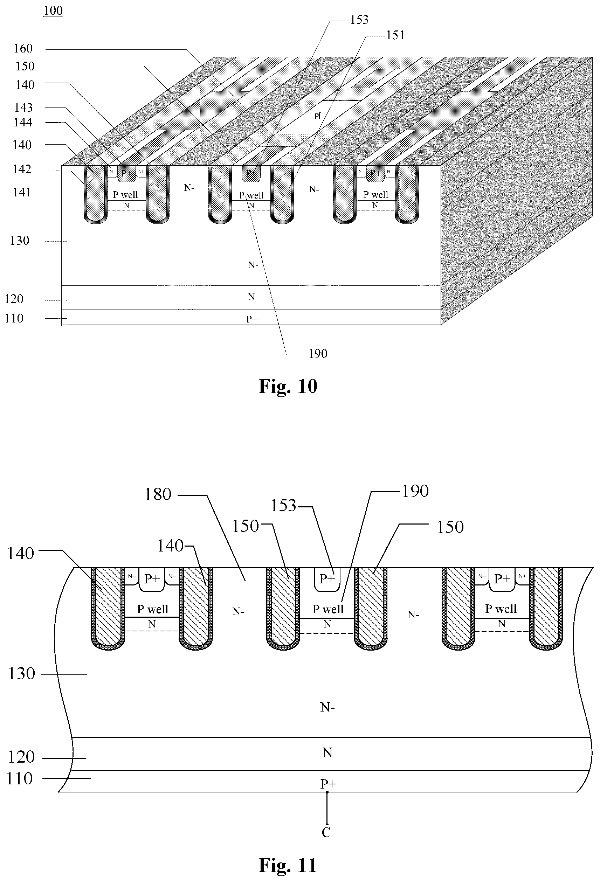

As an alternative to the embodiment in Fig. 2, as shown in Figs. 10 and 11, the main gate 140 and the dummy gate 150 have no dummy gate P well therebetween, and are directly in communication with an N-type drift layer 130. A dummy gate P+ contact region 153 in a second dummy gate P well 190 between two dummy gates 150 is connected to the dummy gate P well main line.

In another embodiment opposite to the embodiment in Fig. 2, as shown in Fig. 3, the first dummy gate P well 180 between one side of the main gate 140 where a conductive trench is not present and the dummy gate 150 includes a dummy gate P+ contact region 153, which may extract a potential by means of the dummy gate P well main line. The dummy gate P well main line may be connected to the emitter or the gate in the cellular region, or connected to an external potential by means of an electrode. In another aspect, a second dummy gate P well 190 between two dummy gate 150 floats.

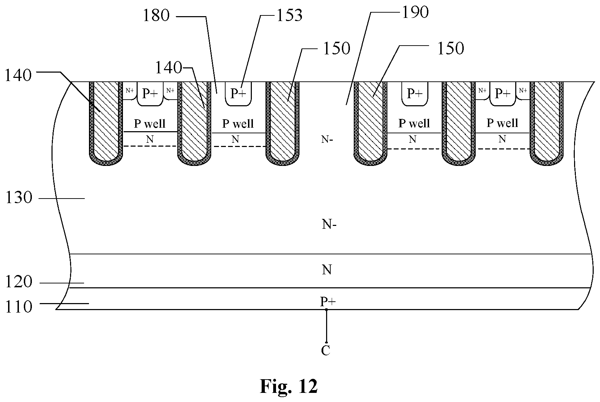

Similarly, as an alternative to the embodiment in Fig. 3, as shown in Fig. 12, the two dummy gates 150 have no dummy gate P well therebetween, and are directly in communication with an N-type drift layer 130. A dummy gate P+ contact region 153 in the first dummy gate P well 180 between the main gate 140 and the dummy gate 150 is connected to the dummy gate P well main line.

In another embodiment, there is only one dummy gate between two adjacent cells, and the dummy gate P+ contact region 153 that extracts a potential is located in the first dummy gate P well 180 between one side of the main gate 140 where a conductive trench is not present and the dummy gate 150. The dummy gate P+ contact region 153 may extract a potential by means of the dummy gate P well main line. The dummy gate P well main line may be connected to the emitter or the gate in the cellular region, or connected to an external potential by means of an electrode.

By utilizing the structure in the above-mentioned embodiments, the dummy gates and the dummy gate P wells are respectively extracted, and same can respectively apply different potentials, thereby effectively avoiding a voltage or current overshoot during the turn-on and turn-off processes insofar as the IGBT performance is not reduced, that is, avoiding a decrease in the device turn-off capability caused by a rise in Vge at the moment of turn-off due to a displacement current which is generated owing to the relatively high Cgc when the dummy gates and the P wells float in the existing technique.

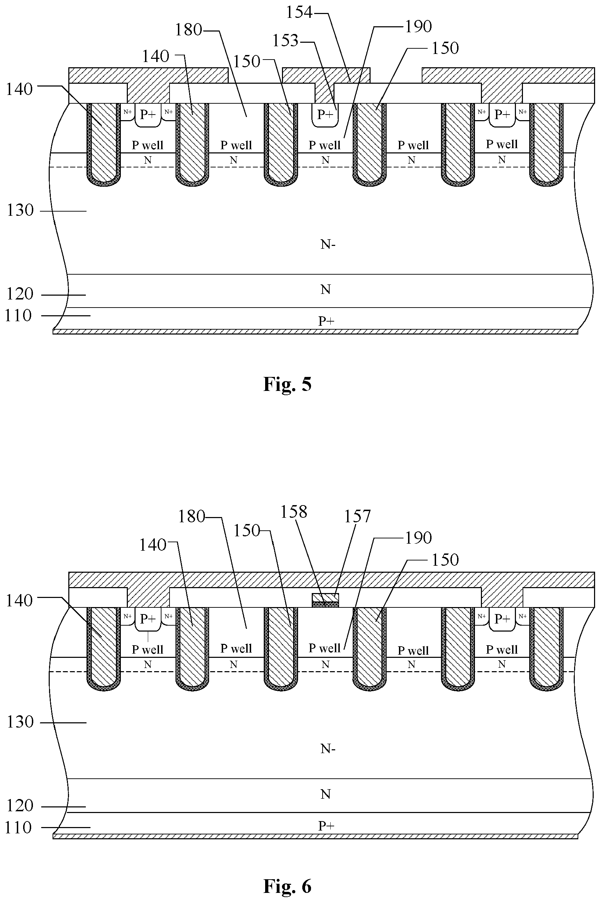

Fig. 4 is a top view of the trench IGBT chip 100 provided by the disclosure, and mainly presents an approach for coupling between a polycrystalline resistor and a metal electrode, which are located near a busbar 200. Through such connection, the external connection of a dummy gate P well can be realized when there is only one layer of metal on the front face, without needing to increase the additional process cost. Specifically, the dummy gate P+ contact region 153 of the second dummy gate P well 190 is connected to a metal layer 156 through a contact aperture 155, and is then connected to the dummy gate P well main line 154 by means of a polycrystalline resistor 157. An isolation oxide layer 158 with a thickness of 1000 A to 1300 A is present on the surfaces of a polycrystalline resistor 156 and a semiconductor. The polycrystalline resistor 156 is located in the trench direction, and will not affect the cellular region even if the polycrystalline resistor 156 has a potential. Figs. 5 and 6 are respectively sectional views of different surface areas, and their schematic diagrams present the connection characteristics of a dummy P well. Fig. 5 is a sectional view of the vicinity of an area where a P well extracts an electrode, and Fig. 6 is a sectional view of the vicinity of a P well not extracting an electrode, where a polycrystalline resistor wiring may be present on the surface of the P well.

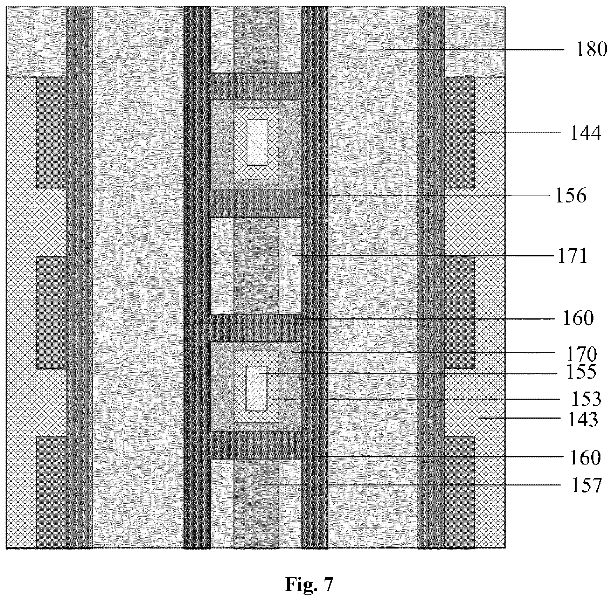

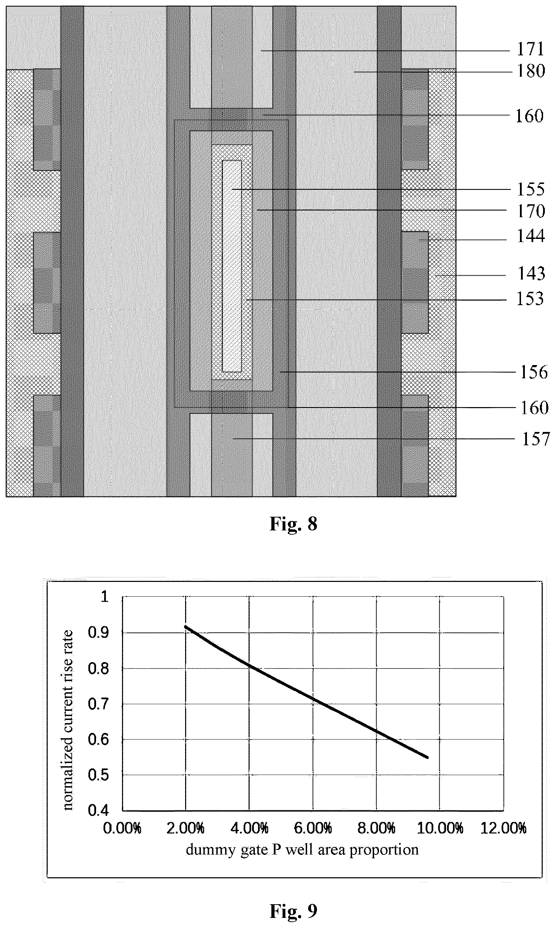

Those skilled in the art would understand that, in an IGBT chip, the area of a dummy gate P well significantly affects a current rise rate di/dt during turn-on and turn-off processes. As shown in Fig. 9, when the dummy gate P well is grounded, the current rise rate di/dt approximately linearly decreases along with the increase of the area of the dummy gate P well. In one preferred embodiment of the disclosure, as shown in Fig. 7, the trench IGBT chip 100 further includes at least two dummy gates 150. A plurality of transverse trenches 160 are provided between two adjacent dummy gates 150, and the plurality of transverse trenches 160 are perpendicular to the length direction of the dummy gates 150, so as to physically divide a second dummy gate P well 190 into a plurality of dummy gate active regions 170 and a plurality of dummy gate dummy regions 171, which are alternately arranged. A dummy gate P well in the dummy gate active region 170 is connected to a dummy gate P well main line by means of a dummy gate P+ contact region 153 that is disposed in the dummy gate P well as stated above, and a dummy gate P well in the dummy gate dummy region 171 floats. In this way, different quantities of potential dummy gate P wells can be designed according to the requirements, such that the adjustment of the area of the dummy gate P well can be realized by means of increasing the quantity of potential dummy gate P wells.

Furthermore, as shown in Fig. 8, the dummy gate active regions 170 is included between two dummy gates 150 of the IGBT chip 100, and is provided with a potential second dummy gate P well 190, which is connected to the dummy gate P well main line by means of the dummy gate P+ contact region 153 as stated above. The dummy gate P well in the dummy gate dummy region 171 floats. The length of the potential second dummy gate P well 190 and the dummy gate P+ contact region 153 increases, so as to increase the area of the dummy gate P well.

It should be understood that the disclosure is explained and described above on the basis of a strip-shaped cell, but the disclosure may be also adapted to the structures such as a quadrate cell, a hexagonal cell and a circular cell.

In addition, it should be understood that the disclosure is explained and described above on the basis of a non-through structure, but the disclosure is also adapted to a through structure and a soft-through structure.

By utilizing the trench IGBT chip provided in the application, the device turn-off capability is avoided from being reduced caused by a rise in Vge at the moment of turn-off due to a displacement current which is generated owing to the relatively high Cgc when the dummy gates and the P wells float. The connection method for the dummy gate P wells is adjusted via a layout, thereby realizing the quantitative adjustment of a current rise rate (di/dt) according to the application requirements, improving the anti-electromagnetic-interference capability of the system, and improving the electromagnetic compatibility between the device and the system. The IGBT structure with controllable di/dt in the disclosure does not affect the turn-off safe working region of the chip and slightly affects a turn-off loss (Eoff), but can improve the compromise relationship between a turn-on loss (Eon) and a reverse recovery loss (Erec). The grounding proportion of the dummy gate P wells can be increased, so as to decrease a conducting speed di/dt, such that the turn-on loss is increased and the turn-off loss is decreased. The grounding proportion of the dummy gate P wells can be decreased, so as to increase the conducting speed di/dt, such that the turn-on loss is decreased and the Erec is increased. An electrode can be extracted from the dummy gate P wells, such that the dummy gate P wells apply different potentials in the IGBT conducting, turn-on and turn-off processes, thereby obtaining different performances.

In the description of the present disclosure, it is to be understood that the terms of "above", "below", "bottom", "top", "front", "rear", "inside", "outside", "left", "right", etc. indicating orientation or position relationships are based on the orientation or position relationship shown in the accompanying drawings and are intended to facilitate the description of the present disclosure and simplify the description only, rather than indicating or implying that an apparatus or element referred to must have a particular orientation or be constructed and operated in a particular orientation, and will not to be interpreted as limiting the disclosure.

Although the disclosure is described herein with reference to particular implementations, it should be understood that these embodiments are merely examples for the principle and application of the disclosure. Therefore, it should be understood that many modifications can be made to the exemplary embodiments, and other arrangements can be designed, without departing from the spirit and scope of the disclosure defined by the appended claims. It should be understood that the features in different dependent claims and the features described herein can be combined in a manner different from that described by the original claims. It can also be understood that the features described in conjunction with a single embodiment can be used in other embodiments.

## Claims

1. A trench IGBT chip, **characterized by** comprising:
an N-type drift layer;
a plurality of parallel cells, wherein each of the cells comprises two main gates disposed in a first trench, which is formed by etching downwards, in an upper surface of the N-type drift layer, and the two main gates extend along the surface of the N-type drift layer and are distributed in parallel; and
dummy gates located between the cells and disposed in a second trench, which is formed by etching downwards, in the upper surface of the N-type drift layer, wherein the dummy gates are parallel to the main gates,
wherein each of the dummy gates extracts a potential by means of a dummy gate main line; and a dummy gate P+ contact region in a first dummy gate P well between one of the main gates and one of the dummy gates or in a second dummy gate P well between two dummy gate P wells extracts a potential by means of a dummy gate P well main line.

2. The trench IGBT chip according to claim 1, **characterized in that** the dummy gate main line is connected to an emitter or a gate of a cellular region, and the dummy gate P well main line is connected to the emitter or the gate in the cellular region.

3. The trench IGBT chip according to claim 2, **characterized by** comprising more than one dummy gate, wherein when the first dummy gate P well extracts a potential, the second dummy gate P well floats, or when the second dummy gate P well extracts a potential, the first dummy gate P well floats.

4. The trench IGBT chip according to claim 3, **characterized in that** the dummy gate P+ contact region is connected by means of a metal electrode, and a polycrystalline resistor is connected to the dummy gate P well main line.

5. The trench IGBT chip according to claim 4, **characterized in that** an isolation oxide layer is disposed between the polycrystalline resistor and the surface of the chip.

6. The trench IGBT chip according to claim 5, **characterized in that** the isolation oxide layer has a thickness of 1000 A to 1300 A.

7. The trench IGBT chip according to claim 2, **characterized by** comprising a single dummy gate, wherein the dummy gate P+ contact region in the first dummy gate P well extracts a potential.

8. The trench IGBT chip according to any one of claims 1 to 7, **characterized by** comprising at least two dummy gates, wherein a plurality of transverse trenches are provided between adjacent dummy gates, and are perpendicular to a length direction of the dummy gates, so as to divide the dummy gate P well into a plurality of dummy gate active regions and a plurality of dummy gate dummy regions, which are alternately arranged; and wherein the dummy gate P+ contact region is provided in dummy gate P wells in the dummy gate active regions, and dummy gate P wells in the dummy gate dummy regions float.

9. The trench IGBT chip according to any one of claims 1 to 7, **characterized in that** each of the cells has a hexagonal cellular structure, and the plurality of cells are distributed on the N-type drift layer in a honeycomb shape; or
each of the cells has a quadrate cellular structure, and the plurality of cells are distributed on the N-type drift layer in matrix; or
each of the cells has a strip-shaped cellular structure, and the plurality of cells are distributed side by side on the N-type drift layer.

10. The trench IGBT chip according to any one of claims 1 to 7, **characterized in that** the N-type drift layer further comprises a through structure, a soft-through structure or a non-through structure below same.

11. The trench IGBT chip according to any one of claims 1 to 7, **characterized in that** a main gate P well between the two main gates comprises a main gate P+ contact region and main gate N+ emitters disposed at opposite sides of the main gate P+ contact region.

12. The trench IGBT chip according to any one of claims 1 to 7, **characterized by** further comprising:
a P+ collector layer; and
an N-type buffer layer disposed between the P+ collector layer and the N-type drift layer.
